# EUROPEAN PATENT APPLICATION

(11) **EP 4 621 829 A1**
(43) Date of publication of application: **24.09.2025**
(21) Application number: 25165068.5
(22) Date of filing: 20.03.2025
(51) Int. Cl.: H01L 21/3213

(54) **CLEANING METHOD OF SEMICONDUCTOR DEVICE, CLEANING APPARATUS OF SEMICONDUCTOR DEVICE AND SEMICONDUCTOR CLEANING COMPOSITION**

(30) Priority: 20.03.2024 TW 113110238
(71) Applicant: Daxin Materials Corporation, Taichung City 407 (TW)
(72) Inventor: SHIH, Yu-Min, 407 Taichung City (TW); SU, Zih-Cheng, 407 Taichung City (TW); WEI, Tsu-Chun, 407 Taichung City (TW); PENG, Shao-Yang, 407 Taichung City (TW)
(74) Representative: Ström & Gulliksson AB

(57) **Abstract**

A cleaning method of a semiconductor device includes the steps as follows. A semiconductor cleaning composition is provided, which includes a mixture and hydrogen peroxide. The semiconductor cleaning composition is contacted with a semiconductor device to clean the semiconductor device. The semiconductor device includes a titanium composition and an aluminum composition. The mixture includes ammonium hydroxide, an organic solvent and an etch stop layer corrosion inhibitor. A weight ratio of the ammonium hydroxide to the etch stop layer corrosion inhibitor is 1:1 to 20:1. An etching rate of the semiconductor cleaning composition for the titanium composition is not less than 170 Å/min, and an etching rate of the semiconductor cleaning composition for the aluminum composition is not greater than 1 Å/min.

## Description

### BACKGROUND

### Technical Field

The present disclosure relates to a cleaning method of a semiconductor device, a cleaning apparatus of a semiconductor device and a semiconductor cleaning composition. More particularly, the present disclosure relates to a cleaning method of a semiconductor device, a cleaning apparatus of a semiconductor device and a semiconductor cleaning composition which can remove etch residues and titanium compounds.

### Description of Related Art

In the manufacturing process of semiconductor or microelectronic devices, the patterning of semiconductor or dielectric layers is usually achieved by multiple photoresist masking and dry etching processes. In dry etching, etch residues will be formed in the vias or trenches of the semiconductor. The aforementioned etch residues includes fluorocarbon-based polymer (CFx polymer) and metal fluoride, and a suitable cleaning composition must be selected to remove the residues. In addition, to simplify the subsequent processes, it is sometimes necessary to remove the hard mask made of titanium compounds, such as titanium nitride, when removing the residues. In this case, the cleaning composition needs to be equipped with the ability to remove titanium compounds.

However, in the removal of titanium compounds, there may exist poor removal efficiency or corrosion of metal lines (which can be made of copper, cobalt, aluminum or tungsten), etch stop layers (which can be made of aluminum oxide or silicon carbide) and dielectric layers in the device. It will damage the structure of semiconductor or microelectronic device. Therefore, conventional cleaning compositions cannot achieve the goal of quickly removing titanium compounds while simultaneously avoiding corrosion of aluminum compounds, and the cleaning effect thereof is still unsatisfactory.

### SUMMARY

According to one embodiment of the present disclosure, a cleaning method of a semiconductor device includes the steps as follows. A semiconductor cleaning composition is provided, which includes a mixture and hydrogen peroxide. A semiconductor device including a titanium composition and an aluminum composition is contacted with the semiconductor cleaning composition, the titanium composition includes at least one of titanium and a titanium compound, and the aluminum composition includes at least one of aluminum and an aluminum compound. The mixture includes ammonium hydroxide, an organic solvent and an etch stop layer corrosion inhibitor. The etch stop layer corrosion inhibitor is selected from a group consisting of (1-hydroxy-1-phosphonoethyl)phosphonic acid, nitrilotrimethylenetris(phosphonic acid), {ethane-1,2-diylbis[nitrilobis(methylene)]}tetrakis(phosphonic acid), [hexane-1,6-diylbis[nitrilobis(methylene)]]tetrakisphosphonic acid and [(bis{2-[bis(phosphonomethyl)amino]ethyl}amino)methyl]phosphonic acid. A weight ratio of the ammonium hydroxide to the etch stop layer corrosion inhibitor is 1:1 to 20:1. An etching rate of the semiconductor cleaning composition for the titanium composition is not less than 170 Å/min, and an etching rate of the semiconductor cleaning composition for the aluminum composition is not greater than 1 Å/min.

According to the aforementioned cleaning method of the semiconductor device, wherein making the semiconductor cleaning composition be in contact with the semiconductor device can be performed by spraying the semiconductor cleaning composition onto a surface of the semiconductor device while the semiconductor device is rotated.

According to another embodiment of the present disclosure, a cleaning apparatus of a semiconductor device includes a cleaning composition delivery device and a cleaning chamber. The cleaning composition delivery device is for providing a semiconductor cleaning composition, which includes a mixture and hydrogen peroxide. The cleaning chamber is communicated with the cleaning composition delivery device, wherein the cleaning chamber is configured for accommodating a semiconductor device. The semiconductor cleaning composition is in contact with the semiconductor device in the cleaning chamber, so as to clean the semiconductor device, the semiconductor device includes a titanium composition and an aluminum composition, the titanium composition includes at least one of titanium and a titanium compound, and the aluminum composition includes at least one of aluminum and an aluminum compound. The mixture includes ammonium hydroxide, an organic solvent and an etch stop layer corrosion inhibitor. The etch stop layer corrosion inhibitor is selected from a group consisting of (1-hydroxy-1-phosphonoethyl)phosphonic acid, nitrilotrimethylenetris(phosphonic acid), {ethane-1,2-diylbis[nitrilobis(methylene)]}tetrakis(phosphonic acid), [hexane-1,6-diylbis[nitrilobis(methylene)]]tetrakisphosphonic acid and [(bis{2-[bis(phosphonomethyl)amino]ethyl}amino)methyl]phosphonic acid. A weight ratio of the ammonium hydroxide to the etch stop layer corrosion inhibitor is 1:1 to 20:1.

According to the aforementioned cleaning apparatus of the semiconductor device, wherein the cleaning chamber can include a rotating element, the semiconductor device can be disposed on the rotating element, and the cleaning composition delivery device can spray the semiconductor cleaning composition onto a surface of the semiconductor device while the semiconductor device is rotated.

According to one another embodiment of the present disclosure, a semiconductor cleaning composition includes a mixture and hydrogen peroxide. The mixture includes ammonium hydroxide, an organic solvent and an etch stop layer corrosion inhibitor. The etch stop layer corrosion inhibitor is selected from a group consisting of (1-hydroxy-1-phosphonoethyl)phosphonic acid, nitrilotrimethylenetris(phosphonic acid), {ethane-1,2-diylbis[nitrilobis(methylene)]}tetrakis(phosphonic acid), [hexane-1,6-diylbis[nitrilobis(methylene)]]tetrakisphosphonic acid and [(bis{2-[bis(phosphonomethyl)amino]ethyl}amino)methyl]phosphonic acid. A weight ratio of the ammonium hydroxide to the etch stop layer corrosion inhibitor is 1:1 to 20:1.

According to the aforementioned semiconductor cleaning composition, wherein a pH value of the mixture can be 6 to 10.

According to the aforementioned semiconductor cleaning composition, wherein as a total weight of the semiconductor cleaning composition is 100%, a weight ratio of the hydrogen peroxide in the semiconductor cleaning composition can be 10% to 25%.

According to the aforementioned semiconductor cleaning composition, wherein the organic solvent can be selected from a group consisting of alcohol, ether, glycol ether, sulfoxide, sulfone, amide, pyrrolidone and imidazolinone.

According to the aforementioned semiconductor cleaning composition, wherein the organic solvent can be selected from a group consisting of methanol, ethanol, isopropanol, n-butanol, isobutanol, ethylene glycol, 1,2-propanediol, 1,2-butanediol, 1,4-butanediol, ethylene glycol monomethyl ether, ethylene glycol dimethyl ether, ethylene glycol methyl ethyl ether, ethylene glycol monoethyl ether, ethylene glycol diethyl ether, ethylene glycol monobutyl ether, ethylene glycol tert-butyl ether, diethylene glycol, diethylene glycol monomethyl ether, diethylene glycol dimethyl ether, diethylene glycol monoethyl ether, diethylene glycol diethyl ether, diethylene glycol monobutyl ether, diethylene glycol dibutyl ether, diethylene glycol tert-butyl ether, triethylene glycol dimethyl ether, tetraethylene glycol dimethyl ether, propylene glycol dimethyl ether, propylene glycol methyl propyl ether, propylene glycol methyl butyl ether, propylene glycol monobutyl ether, propylene glycol tert-butyl ether, dipropylene glycol monomethyl ether, dipropylene glycol dimethyl ether, dipropylene glycol methyl propyl ether, dipropylene glycol methyl butyl ether, dipropylene glycol monobutyl ether, 2,5,7,10-tetraoxaundecane, 4,7-dimethyl-2,5,9-trioxadecane, 4-methyl-2,5,9-trioxadecane, tetrahydrofurfuryl alcohol, dimethyl sulfoxide, dimethyl sulfone, sulfolane, N,N-dimethylformamide, N,N-dimethylacetamide, N,N-diethylformamide, N-methyl-2-pyrrolidone, N-ethyl-2-pyrrolidone, N-isobutyl-2-pyrrolidone, 1,3-dimethylimidazolidin-2-one and tetrahydro-1,3-dimethyl-1H-pyrimidin-2-one.

According to the aforementioned semiconductor cleaning composition, wherein the mixture can further include water, and as a total weight of the mixture is 100%, a weight ratio of the organic solvent in the mixture can be 20% to 70%.

According to the aforementioned semiconductor cleaning composition, wherein the mixture can further include a metal corrosion inhibitor.

According to the aforementioned semiconductor cleaning composition, wherein the metal corrosion inhibitor can be selected from a group consisting of benzotriazole, 2,2'-[[(methyl-1H-benzotriazole-1-yl)methyl]imino]bisethanol, 4-nitrobenzotriazole, 5-nitrobenzotriazole, 4-methylbenzotriazole, 5-methylbenzotriazole, 1-phenylbenzotriazole, benzotriazole-4-carboxylic acid, benzotriazole-5-carboxylic acid, 4-aminobenzotriazole, 5-aminobenzotriazole, hydroxybenzotriazole, 2-(5-aminopentyl)benzotriazole and 5-benzenethiol-benzotriazole.

According to the aforementioned semiconductor cleaning composition, wherein the mixture can further include a chelating agent.

According to the aforementioned semiconductor cleaning composition, wherein the chelating agent can be selected from a group consisting of glycine, alanine, cysteine, methionine, aspartic acid, asparagine, glutamic acid, glutamine, arginine, serine, histidine, iminodiacetic acid, nitrilotriacetic acid, N,N-bis(carboxymethyl)-β-alanine, ethylenediamine tetraacetic acid, trans-1,2-diaminocyclohexane tetraacetic acid, triethylenetetramine-N,N,N',N",N‴,N‴-hexaacetic acid, diethylenetriamine pentaacetic acid, 1,3-propanediamine-N,N,N',N'-tetraacetic acid, 1,3-diamino-2-propanol-N,N,N',N'-tetraacetic acid, glycol ether diamine tetraacetic acid, (S,S)-ethylenediamine-N,N'-disuccinic acid, N-(2-hydroxyethyl)ethylenediamine-N,N',N'-triacetic acid, N,N'-bis(2-hydroxyethl)glycine and dicarboxymethyl glutamic acid.

### BRIEF DESCRIPTION OF THE DRAWINGS

The present disclosure can be more fully understood by reading the following detailed description of the embodiment, with reference to the accompanying drawings as follows:
Fig. 1 is a flow chart of a cleaning method of a semiconductor device according to one embodiment of the present disclosure.
Fig. 2 is a structural schematic view of a cleaning apparatus of a semiconductor device according to another embodiment of the present disclosure.

### DETAILED DESCRIPTION

The present disclosure will be further exemplified by the following specific embodiments. However, the embodiments can be applied to various inventive concepts and can be embodied in various specific ranges. The specific embodiments are only for the purposes of description, and are not limited to these practical details thereof. Furthermore, in order to simplify the drawings, some conventional structures and elements will be illustrated in the drawings by a simple and schematic way.

### <Cleaning Method of Semiconductor Device>

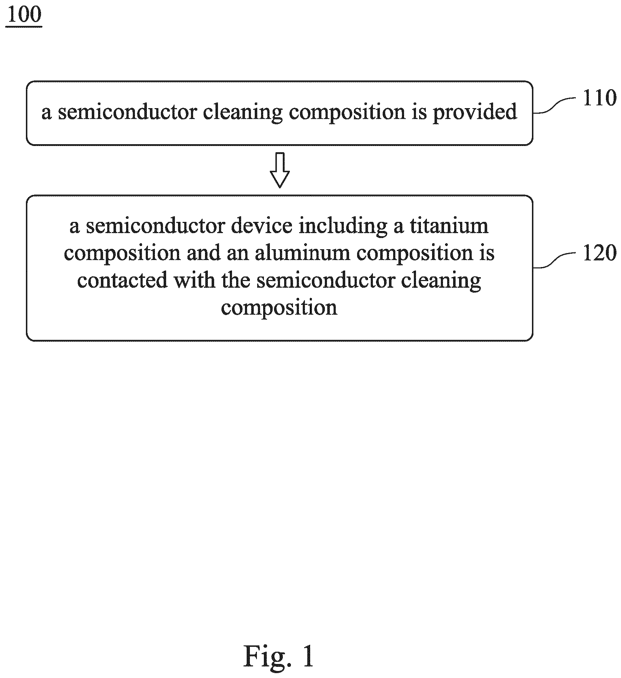

Referring to Fig. 1. Fig. 1 is a flow chart of a cleaning method of a semiconductor device 100 according to one embodiment of the present disclosure. The cleaning method of the semiconductor device 100 includes Step 110 and Step 120.

In detail, Step 110 is to provide a semiconductor cleaning composition, which includes a mixture and hydrogen peroxide. The mixture includes ammonium hydroxide, an organic solvent and an etch stop layer corrosion inhibitor. The detailed composition and proportion of the semiconductor cleaning composition will be described in the following paragraphs, and the details thereof will not be given herein.

Step 120 is to make the semiconductor cleaning composition be in contact with a semiconductor device, so as to clean the semiconductor device. The semiconductor device includes a titanium composition and an aluminum composition, the titanium composition includes at least one of titanium and a titanium compound, and the aluminum composition includes at least one of aluminum and an aluminum compound. In Step 120, an etching rate of the semiconductor cleaning composition for the titanium composition is not less than 170 Å/min, and an etching rate of the semiconductor cleaning composition for the aluminum composition is not greater than 1 Å/min. Therefore, the titanium composition on the semiconductor device can be quickly removed, and the etching of the aluminum composition can be reduced.

The aforementioned etching rate of the semiconductor cleaning composition for the titanium composition can be not less than 200 Å/min. Moreover, it can be not less than 250 Å/min. Moreover, it can be not less than 300 Å/min. Moreover, it can be not less than 350 Å/min. Moreover, it can be not less than 400 Å/min. Moreover, it can be not less than 450 Å/min and not greater than 500 Å/min. The aforementioned etching rate of the semiconductor cleaning composition for the aluminum composition can be not greater than 0.9 Å/min. Moreover, it can be not greater than 0.8 Å/min. Moreover, it can be not greater than 0.7 Å/min. Moreover, it can be not greater than 0.6 Å/min. Moreover, it can be not greater than 0.5 Å/min and not less than 0.01 Å/min. Therefore, the etching rates of the semiconductor cleaning composition for the titanium composition and the aluminum composition can be adjusted, so as to meet the needs of use.

In Step 120, the semiconductor cleaning composition can be sprayed onto a surface of the semiconductor device while the semiconductor device is rotated, so as to make the semiconductor cleaning composition be uniformly in contact with the semiconductor device, which improves the efficiency of removing the titanium composition on the aforementioned surface. It should be mentioned that, in the present disclosure, the aforementioned rotational spraying is only taken as an example. Any method that can make the semiconductor cleaning composition be in contact with the semiconductor device to achieve the cleaning effect (such as immersion, rinsing or spraying under non-rotating conditions) should be within the scope of the present disclosure.

### <Cleaning Apparatus of Semiconductor Device>

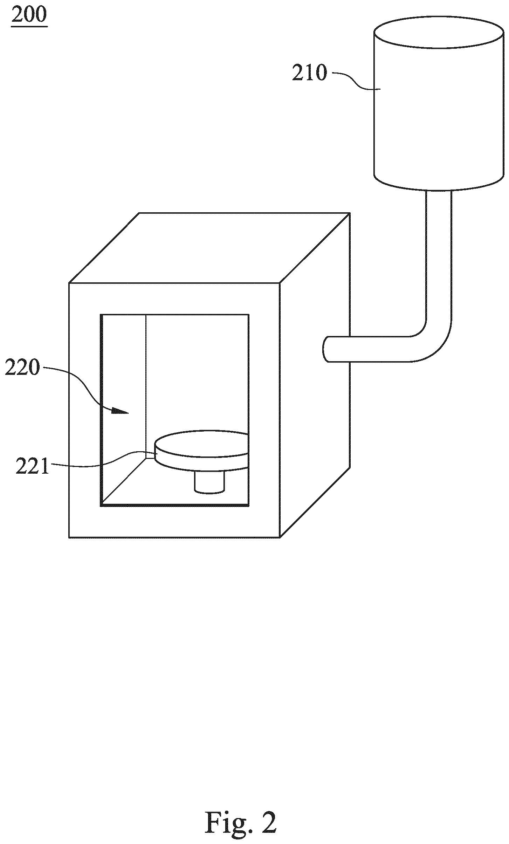

Referring to Fig. 2. Fig. 2 is a structural schematic view of a cleaning apparatus of a semiconductor device 200 according to another embodiment of the present disclosure. The cleaning apparatus of the semiconductor device 200 includes a cleaning composition delivery device 210 and a cleaning chamber 220. The cleaning chamber 220 is communicated with the cleaning composition delivery device 210, and is configured for accommodating a semiconductor device (not shown).

In detail, the cleaning composition delivery device 210 is for providing a semiconductor cleaning composition, which includes a mixture and hydrogen peroxide. The mixture includes ammonium hydroxide, an organic solvent and an etch stop layer corrosion inhibitor. The detailed composition and proportion of the semiconductor cleaning composition will be described in the following paragraphs, and the details thereof will not be given herein.

The semiconductor cleaning composition is in contact with the semiconductor device in the cleaning chamber 220, so as to clean the semiconductor device, and the semiconductor device includes a titanium composition and an aluminum composition. The titanium composition includes at least one of titanium and a titanium compound, and the aluminum composition includes at least one of aluminum and an aluminum compound. The ingredients of the semiconductor cleaning composition can quickly remove the titanium composition on the semiconductor device, and reduce the etching of the aluminum composition.

The cleaning chamber 220 can include a rotating element 221, the semiconductor device can be disposed on the rotating element 221, and the cleaning composition delivery device 210 can spray the semiconductor cleaning composition onto a surface of the semiconductor device while the semiconductor device is rotated. Therefore, the semiconductor cleaning composition can more uniformly contact the semiconductor device, and improves the efficiency of removing the titanium composition on the aforementioned surface. It should be mentioned that, the present disclosure only takes the aforementioned rotating element 221 as an example, but any structure or element (structures such as a tank for immersing the semiconductor device in the semiconductor cleaning composition, or a non-rotating platform for placing the semiconductor device) that can make the semiconductor cleaning composition be in contact with the semiconductor device and achieve the cleaning effect should be within the scope of the present disclosure.

### <Semiconductor Cleaning Composition>

According to one another embodiment of the present disclosure, a semiconductor cleaning composition includes a mixture and hydrogen peroxide, the mixture includes ammonium hydroxide, an organic solvent and an etch stop layer corrosion inhibitor. The etch stop layer corrosion inhibitor is a phosphonic acid compound, and is selected from a group consisting of (1-hydroxy-1-phosphonoethyl)phosphonic acid (HEDP), nitrilotrimethylenetris(phosphonic acid) (NTMP), {ethane-1,2-diylbis[nitrilobis(methylene)]}tetrakis(phosphonic acid) (EDTMP), [hexane-1,6-diylbis[nitrilobis(methylene)]]tetrakisphosphonic acid (HDTMP) and [(bis{2-[bis(phosphonomethyl)amino]ethyl}amino)methyl]phosphonic acid (DTPMP). A weight ratio of ammonium hydroxide to the etch stop layer corrosion inhibitor is 1:1 to 20:1. Moreover, it can be 1:1 to 10:1. Moreover, it can be 1:1 to 7.5:1. Therefore, the etching rate of the semiconductor cleaning composition for etch residues, titanium compositions, metal lines, dielectric layers and etch stop layers can be controlled, which is favorable for improving the efficiency of removing etch residues and titanium compositions, and reducing the corrosion to metal lines, dielectric layers and etch stop layers.

The various types and proportions of materials of the semiconductor cleaning composition will be further described below. However, it should be mentioned that, the semiconductor cleaning composition of the present disclosure only needs to meet the aforementioned composition ratio to achieve the technical effect of the present disclosure. Therefore, the semiconductor cleaning composition of the present disclosure is not limited to the types and proportions of materials listed below.

A pH value of the mixture can be 6 to 10. Moreover, it can be 6.5 to 9.5. Moreover, it can be 7 to 9. By selecting ammonium hydroxide and adjusting the pH value of the mixture, a relatively high etching rate of the titanium composition can be obtained within an appropriate range of pH value, and the effect of inhibiting corrosion of the aluminum composition or other metals can be improved.

As a total weight of the semiconductor cleaning composition is 100%, a weight ratio of hydrogen peroxide in the semiconductor cleaning composition can be 10% to 25%. Moreover, it can be 15% to 25%. Moreover, it can be 18% to 23%. Therefore, the etching rate of the semiconductor cleaning composition for etch residues, titanium compositions, metal lines, dielectric layers and etch stop layers can be further adjusted, so as to meet different application needs.

The organic solvent can be selected from a group consisting of alcohol, ether, glycol ether, sulfoxide, sulfone, amide, pyrrolidone and imidazolinone. Alternatively, the organic solvent can be selected from a group consisting of methanol, ethanol, isopropanol, n-butanol, isobutanol, ethylene glycol, 1,2-propanediol, 1,2-butanediol, 1,4-butanediol, ethylene glycol monomethyl ether, ethylene glycol dimethyl ether, ethylene glycol methyl ethyl ether, ethylene glycol monoethyl ether, ethylene glycol diethyl ether, ethylene glycol monobutyl ether, ethylene glycol tert-butyl ether, diethylene glycol, diethylene glycol monomethyl ether, diethylene glycol dimethyl ether, diethylene glycol monoethyl ether, diethylene glycol diethyl ether, diethylene glycol monobutyl ether, diethylene glycol dibutyl ether, diethylene glycol tert-butyl ether, triethylene glycol dimethyl ether, tetraethylene glycol dimethyl ether, propylene glycol dimethyl ether, propylene glycol methyl propyl ether, propylene glycol methyl butyl ether, propylene glycol monobutyl ether, propylene glycol tert-butyl ether, dipropylene glycol monomethyl ether, dipropylene glycol dimethyl ether, dipropylene glycol methyl propyl ether, dipropylene glycol methyl butyl ether, dipropylene glycol monobutyl ether, 2,5,7,10-tetraoxaundecane, 4,7-dimethyl-2,5,9-trioxadecane, 4-methyl-2,5,9-trioxadecane, tetrahydrofurfuryl alcohol (THFA), dimethyl sulfoxide (DMSO), dimethyl sulfone, sulfolane, N,N-dimethylformamide (DMF), N,N-dimethylacetamide (DMAc), N,N-diethylformamide (DEF), N-methyl-2-pyrrolidone (NMP), N-ethyl-2-pyrrolidone (NEP), N-isobutyl-2-pyrrolidone, 1,3-dimethylimidazolidin-2-one (DMI) and tetrahydro-1,3-dimethyl-1H-pyrimidin-2-one (DMPU). Therefore, different organic solvents can be selected according to the type of target substance to be removed.

The mixture can further include water, and as a total weight of the mixture is 100%, a weight ratio of the organic solvent in the mixture can be 20% to 70%. Moreover, it can be 25% to 65%. Moreover, it can be 30% to 60%. Moreover, it can be 35% to 55%. By adjusting the ratio of the organic solvent and water, the corrosion of the semiconductor cleaning composition to the aluminum composition can be further reduced, and the effect of removing etch residues can be improved.

The mixture can further include a metal corrosion inhibitor. The metal corrosion inhibitor can be an azole compound, and can be selected from a group consisting of benzotriazole (BTA), 2,2'-[[(methyl-1H-benzotriazole-1-yl)methyl]imino]bisethanol, 4-nitrobenzotriazole, 5-nitrobenzotriazole, 4-methylbenzotriazole, 5-methylbenzotriazole (5mBTA), 1-phenylbenzotriazole, benzotriazole-4-carboxylic acid, benzotriazole-5-carboxylic acid, 4-aminobenzotriazole, 5-aminobenzotriazole, hydroxybenzotriazole, 2-(5-aminopentyl)benzotriazole and 5-benzenethiol-benzotriazole. The metal corrosion inhibitor can further protect the metal lines, and reduce the corrosion of the semiconductor cleaning composition to the metal lines.

The mixture can further include a chelating agent. The chelating agent can include an amino acid compound, and can be selected from a group consisting of glycine, alanine, cysteine, methionine, aspartic acid, asparagine, glutamic acid, glutamine, arginine, serine, histidine, iminodiacetic acid (IDA), nitrilotriacetic acid (NTA), N,N-bis(carboxymethyl)-β-alanine, ethylenediamine tetraacetic acid (edetic acid; EDTA), trans-1,2-diaminocyclohexane tetraacetic acid (CyDTA), triethylenetetramine-N,N,N',N",N‴,N‴-hexaacetic acid (hexaacetic acid; TTHA), diethylenetriamine pentaacetic acid (pentetic acid; DTPA), 1,3-propanediamine-N,N,N',N'-tetraacetic acid (PDTA), 1,3-diamino-2-propanol-N,N,N',N'-tetraacetic acid (DPTA-OH), glycol ether diamine tetraacetic acid (GEDTA), (S,S)-ethylenediamine-N,N'-disuccinic acid (EDDS), N-(2-hydroxyethyl)ethylenediamine-N,N',N'-triacetic acid (HEDTA), N,N'-bis(2-hydroxyethl)glycine (Bicine) and dicarboxymethyl glutamic acid (CMGA).

The chelating agent can be used to stabilize metal ions dissolved in the semiconductor cleaning composition during cleaning, such as titanium ions dissolved from the titanium composition, and to chelate with the metal ions to form a relatively stable chelate. Therefore, by adding the chelating agent, the influence of the metal ions on the properties of the semiconductor cleaning composition can be reduced, which improves the stability of the various ingredients in the semiconductor cleaning composition, and helps to maintain the etching rate of the semiconductor cleaning composition.

A weight ratio of ammonium hydroxide to the chelating agent is 1:1 to 1:20. Moreover, it can be 1:1 to 1:15. Moreover, it can be 1:1 to 1:10. By adjusting the ratio of ammonium hydroxide to the chelating agent, the stability of hydrogen peroxide in the semiconductor cleaning composition can be improved, so as to further improve the etching rate of the semiconductor cleaning composition for the titanium composition and reduce the corrosion of the semiconductor cleaning composition to the aluminum composition or other metal structures.

The present disclosure will be further exemplified by the following specific embodiments so as to facilitate utilizing and practicing the present disclosure completely by the people skilled in the art without over-interpreting and over-experimenting. However, the readers should understand that the present disclosure should not be limited to these practical details thereof, that is, these practical details are used to describe how to implement the materials and methods of the present disclosure and are not necessary.

### <Preparation of Semiconductor Cleaning Composition>

Please refer to Table 1-1 to Table 1-4 below. The compositions and proportions of the mixtures of Example A1 to Example A19 and Comparative Example A1 to Comparative Example A8 are listed in Table 1-1 to Table 1-4, and the abbreviations of the selected materials thereof are as shown in Table 2:

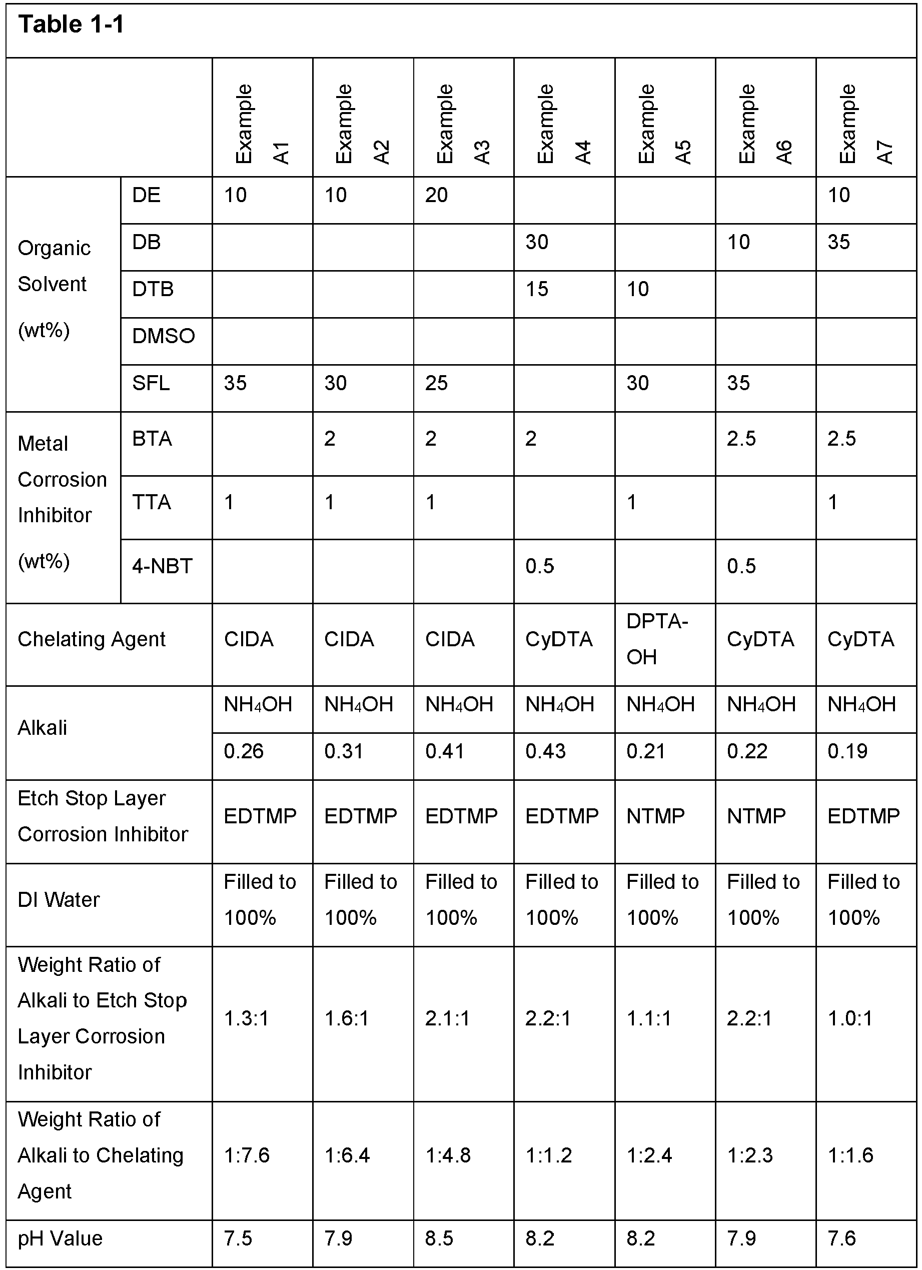

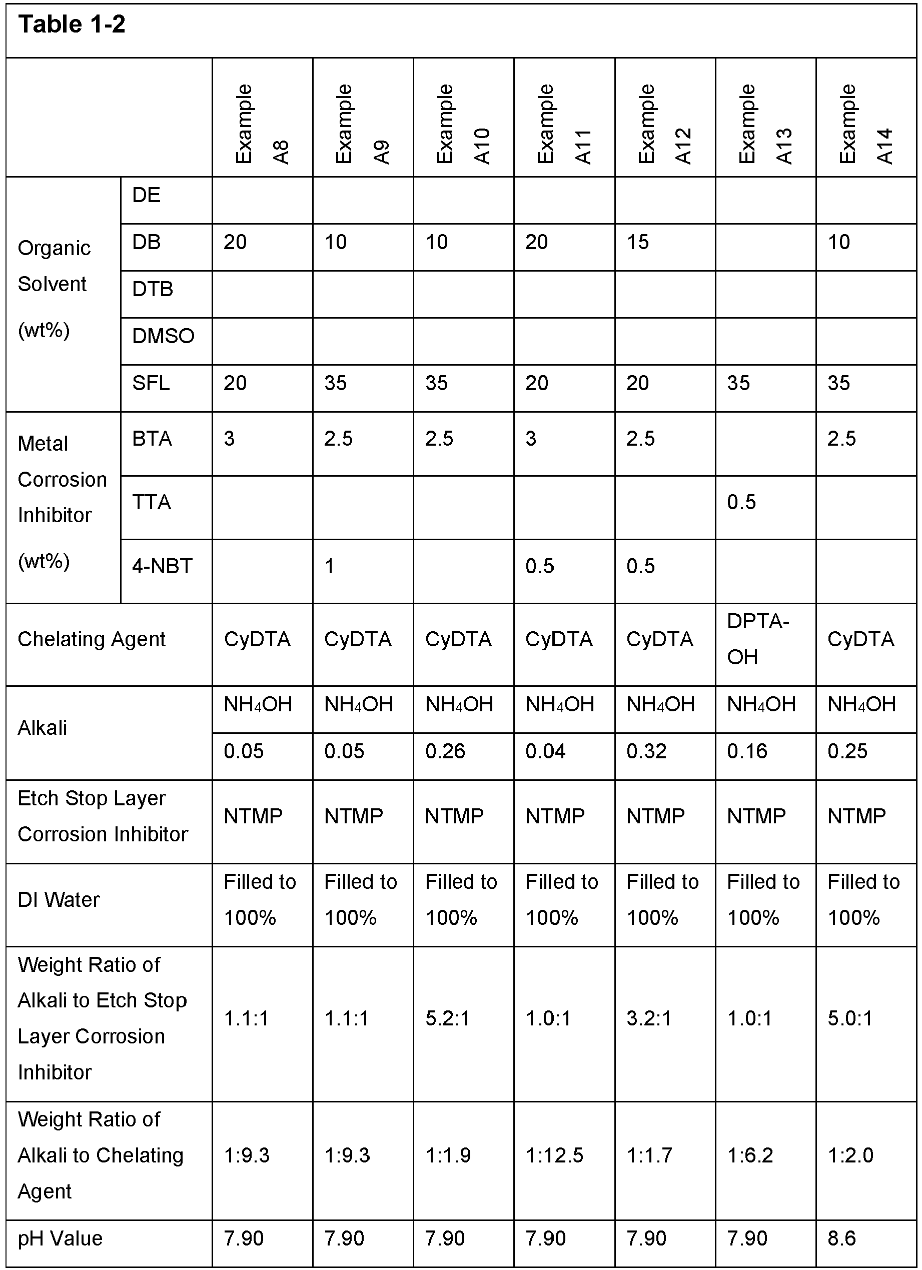

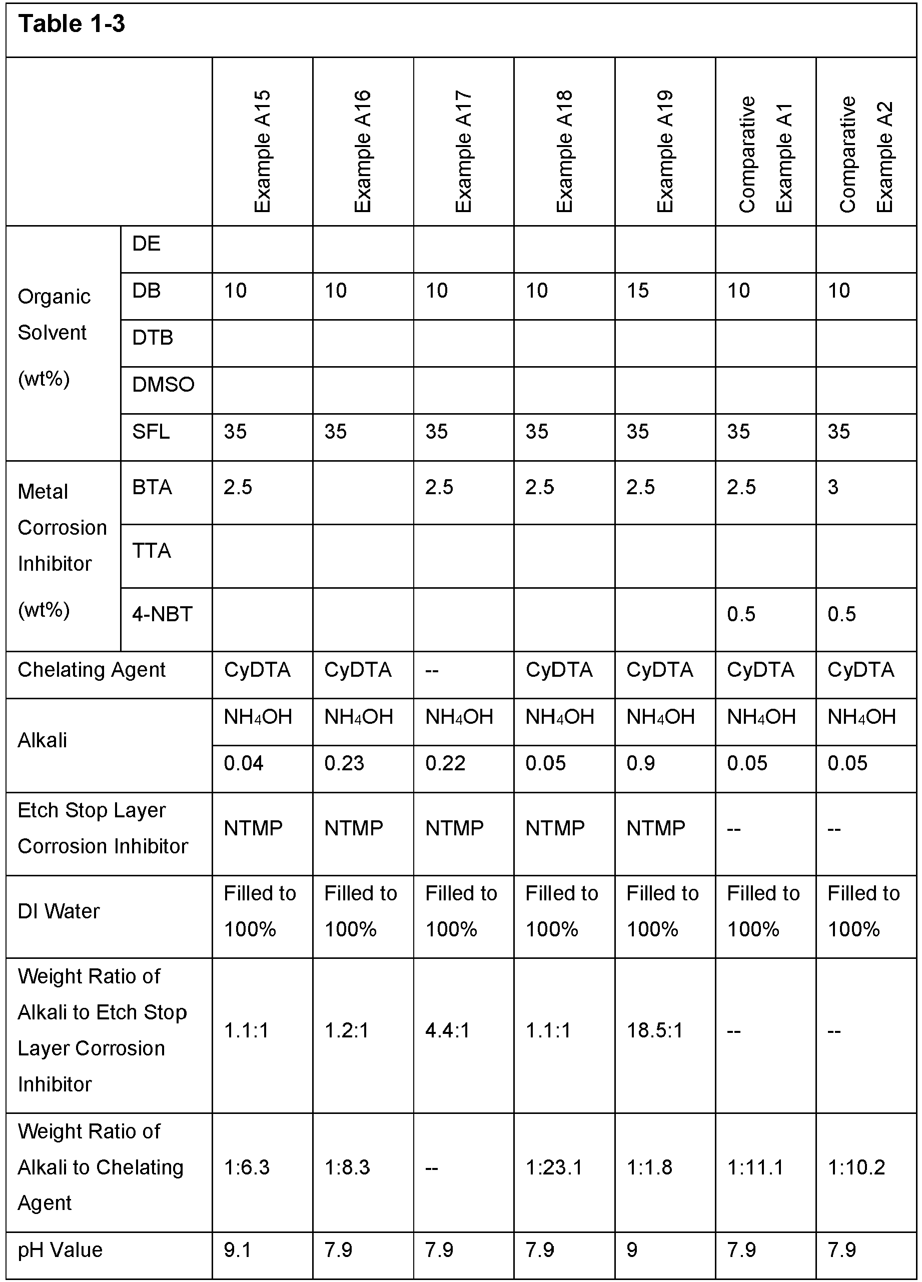

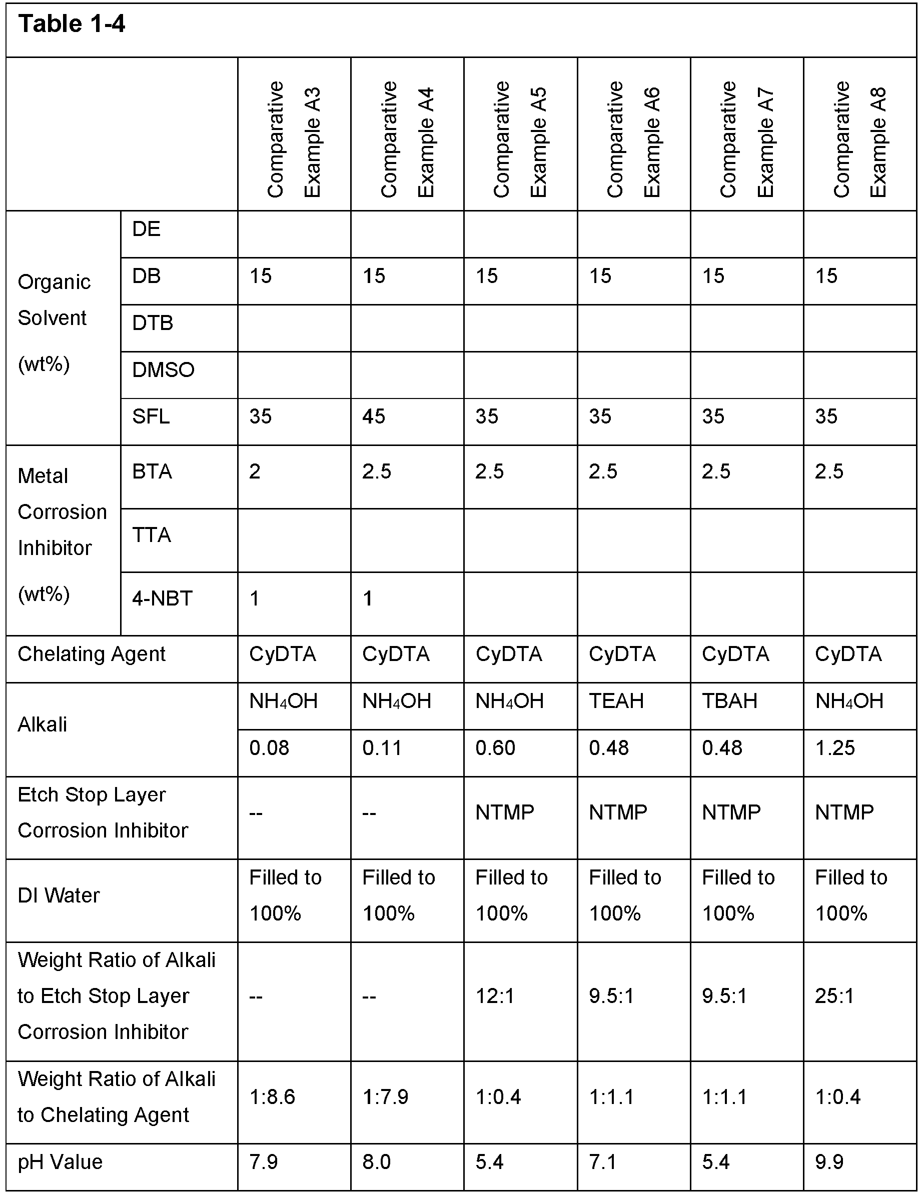

| **Table 2** | |
|---|---|
| Abbreviation | Compound |
| DE | diethylene glycol monoethyl ether |
| DB | diethylene glycol monobutyl ether |
| DTB | diethylene glycol tert-butyl ether |
| DMSO | dimethyl sulfoxide |
| SFL | sulfolane |
| BTA | benzotriazole |
| TTA | tolyltriazole |
| 4-NBT | nitrobenzotriazole |
| NTMP | nitrilotrimethylenetris(phosphonic acid) |
| EDTMP | {ethane-1,2-diylbis[nitrilobis(methylene)]} tetrakis(phosphonic acid) |
| CIDA | N,N-bis(carboxymethyl)-β-alanine |
| CyDTA | trans-1,2-diaminocyclohexane tetraacetic acid |
| DPTA-OH | 1,3-diamino-2-propanol-N,N,N',N'- tetraacetic acid |
| NH₄OH | ammonium hydroxide |
| TEAH | tetraethylammonium hydroxide |
| TBAH | tetrabutylammonium hydroxide |

Next, the mixtures of Example A1 to Example A19 and Comparative Example A1 to Comparative Example A8 were mixed with hydrogen peroxide, so as to prepare the semiconductor cleaning compositions of Example B1 to Example B19 and Comparative Example B1 to Comparative Example B8. The pH values thereof are shown in Table 3 below. In detail, the semiconductor cleaning compositions of Example B1 to Example B19 and Comparative Example B1 to Comparative Example B8 were prepared by mixing the corresponding mixtures with a hydrogen peroxide aqueous solution. The weight percentage concentration of the hydrogen peroxide aqueous solution is 31%, and the weight ratio of the hydrogen peroxide aqueous solution to the mixture was 2:1. In the prepared semiconductor cleaning composition, the weight ratios of hydrogen peroxide, water and the mixture were approximately 20%, 47% and 33%, respectively. It should be mentioned that, although in the examples of the present disclosure, the specific proportion of hydrogen peroxide is limited, the technical effects of the present disclosure can be achieved by different proportions of hydrogen peroxide in practical applications. Therefore, the present disclosure is not limited to the compositions or proportions of the examples.

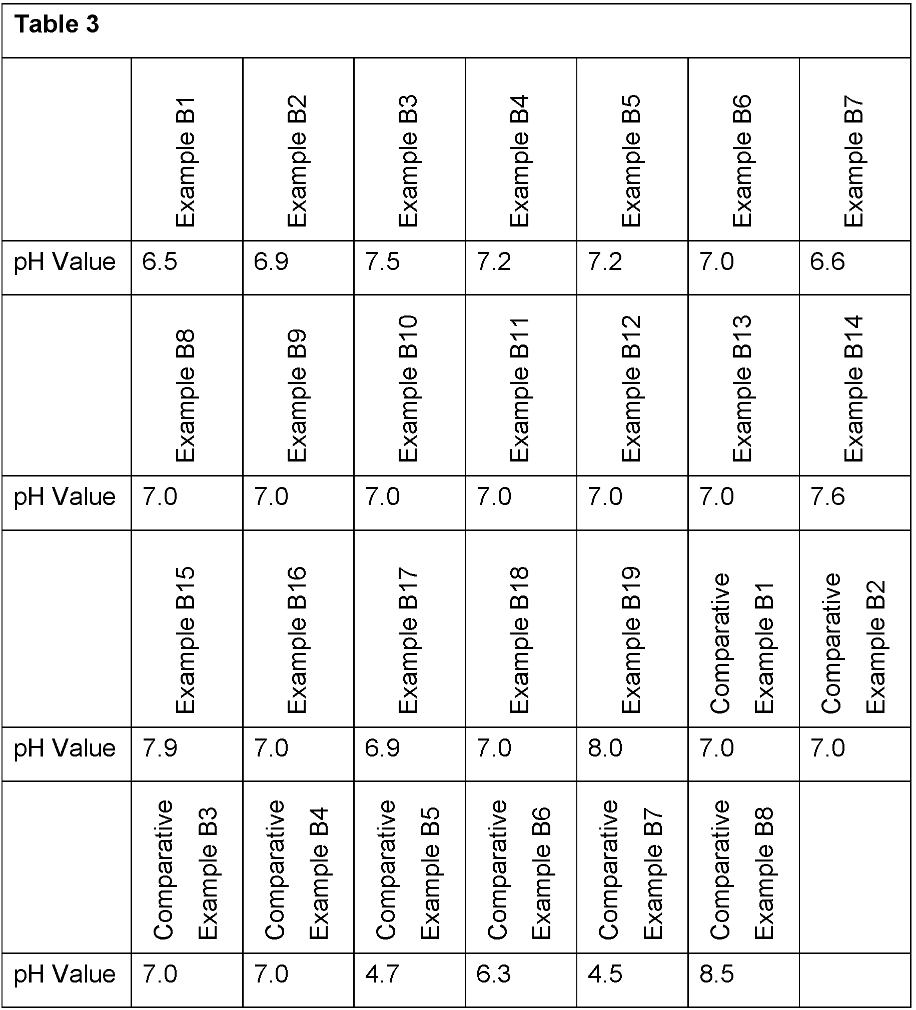

### <Etching Rate of Semiconductor Cleaning Composition for Different Materials>

The etching rates of the semiconductor cleaning compositions of Example B1 to Example B6, Example B13 to Example B15, Example B17 to Example B19 and Comparative Example B1 to Comparative Example B8 for different materials are measured as follows. The measurement method thereof is as follows: different materials were deposited on blank wafers by different deposition methods, and then the deposited wafers were immersed in the aforementioned semiconductor cleaning compositions. A specific temperature is maintained for a specific time in the immersion process, and the etching rate of each material was calculated by measuring the difference of wafer thickness before and after immersion.

The materials used herein include titanium nitride, aluminum oxide (etch stop layer), copper, cobalt and Low k dielectric layer. The immersion time for titanium nitride was 30 seconds, and the thickness was measured by an ellipsometer. The immersion time for aluminum oxide was 10 minutes, and the thickness was measured by the ellipsometer. The immersion time for the Low k dielectric layer was 10 minutes, and the thickness was measured by the ellipsometer. The immersion time for copper and cobalt was both 10 minutes, and the thickness was measured by a four-point probe.

### <Etching Rate of Titanium Nitride and Aluminum Oxide>

Please refer to Table 4 below. The etching rates of titanium nitride and aluminum oxide by the semiconductor cleaning compositions of Example B1 to Example B6, Example B13 to Example B15, Example B17 to Example B19 and Comparative Example B1 to Comparative Example B8 are listed in Table 4.

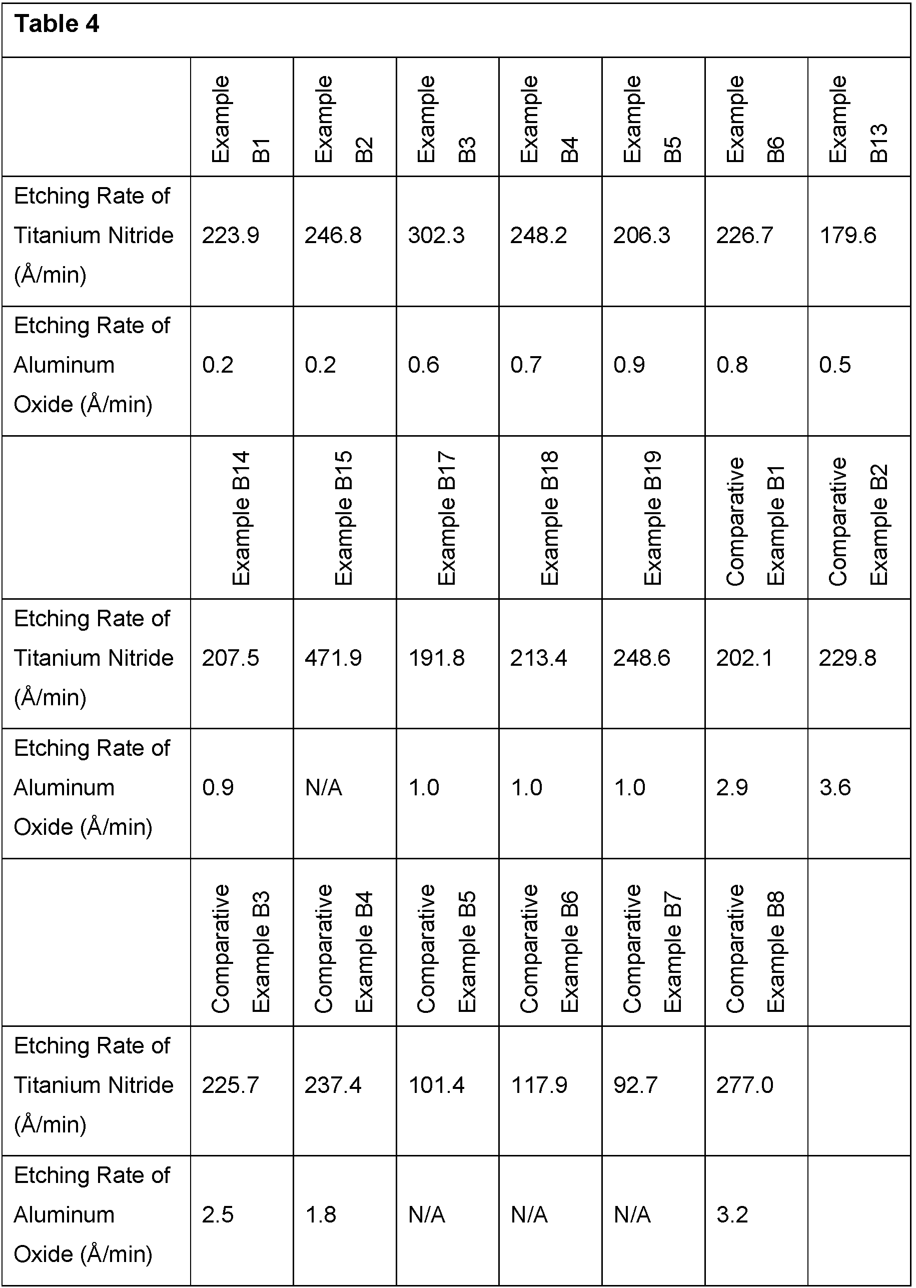

From the results in Table 4, it can be understood that the etching rates of titanium nitride by the semiconductor cleaning compositions of Example B1 to Example B6, Example B13 to Example B15 and Example B17 to Example B19 can all be maintained at over 170 Å per minute. It proves that the aforementioned examples can effectively remove titanium nitride. In addition, since the semiconductor cleaning compositions of Comparative Example B1 to Comparative Example B4 do not include an etch stop layer corrosion inhibitor, the etching rates for aluminum oxide thereof are also significantly higher than other examples. It should be mentioned that, in the semiconductor cleaning compositions of Comparative Example B2 to Comparative Example B4, the proportion of water is reduced sequentially (50 wt% to 55 wt%, 40 wt% to 45 wt% and 30 wt% to 35 wt%, respectively), so it can be observed that the etching rate for aluminum oxide decreases slightly, but the effect thereof is still not as good as adding the etch stop layer corrosion inhibitor.

In addition, by comparing the etching results of the semiconductor cleaning compositions of Example B1, Example B14, Comparative Example B6 and Comparative Example B7, it can be understood that the use of ammonium hydroxide significantly increases the etching rate of titanium nitride.

### <Etching Rate of Copper and Cobalt>

Please refer to Table 5 below. The etching rates of copper and cobalt by the semiconductor cleaning compositions of Example B5 to Example B7, Example B9, Example B13, Example B16 and Example B18 are listed in Table 5.

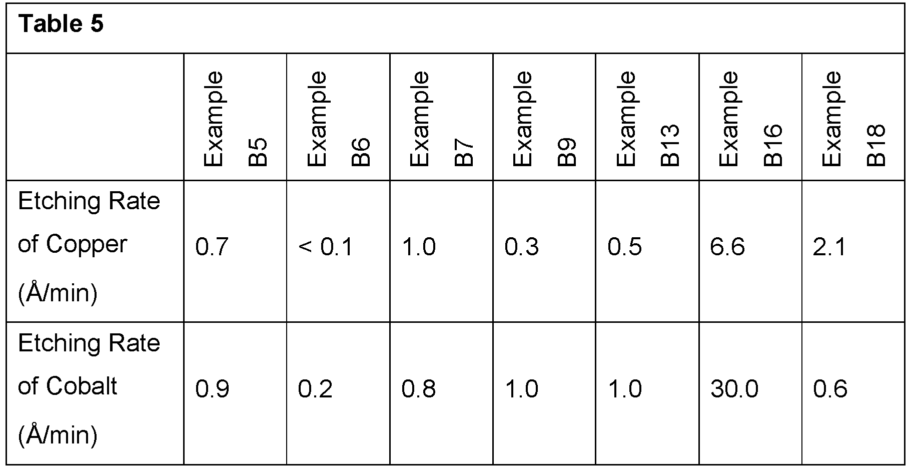

From the results in Table 5, it can be understood that the etching rates of copper and cobalt by the semiconductor cleaning compositions of Example B5 to Example B7, Example B9 and Example B13 are all not greater than 1 Å per minute. In addition, in the semiconductor cleaning compositions of Example B16 and Example B18, it can be understood that by adding or not adding the chelating agent and by adjusting the ratio of the chelating agent to the alkali, the etching rate of the semiconductor cleaning composition for copper and cobalt can be changed.

### <Etching Rate of Dielectric Layer>

Please refer to Table 6 below. The etching rates of the Low k dielectric layers by the semiconductor cleaning compositions of Example B1 to Example B3 are listed in Table 6.

| **Table 6** | | | |
|---|---|---|---|
| | Example B1 | Example B2 | Example B3 |
| Etching Rate of Low k Dielectric Layer (Å/min) | 0.6 | 1.0 | 0.9 |

From the results in Table 6, it can be understood that the etching rates of the Low k dielectric layers by the semiconductor cleaning compositions of Example B1 to Example B3 are all not greater than 1 Å per minute, which proves that the semiconductor cleaning composition has low corrosion to the dielectric layer.

### <Stability of Continuous Operation>

The etching rates of the semiconductor cleaning compositions of Example B8 to Example B12 under continuous operation at different times are measured as follows. In the present test, the deposited wafer was immersed in the aforementioned semiconductor cleaning composition, and the etching rates of titanium nitride and aluminum oxide thereof were measured at different time points. The results of the present test are listed in Table 7 below.

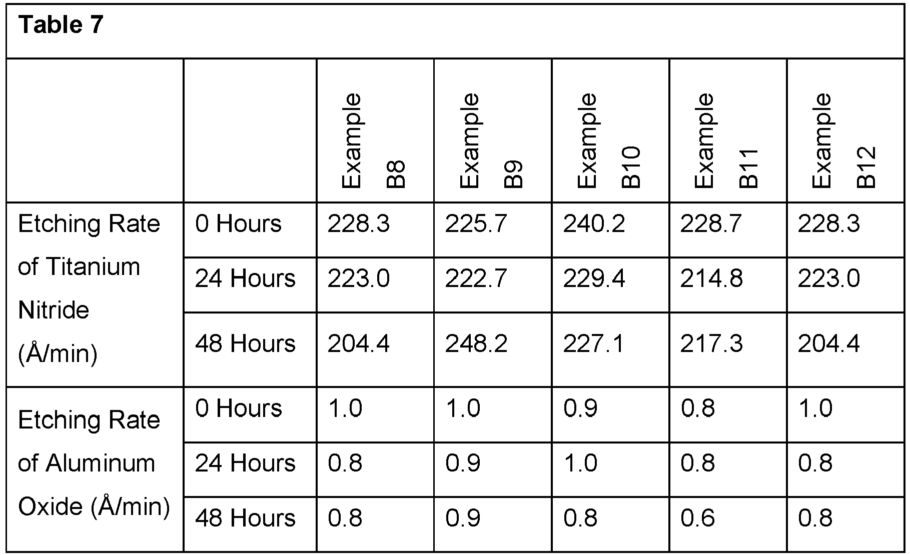

From the results in Table 7, it can be understood that under the condition of continuous operation for 48 hours, the etching rates of titanium nitride and aluminum oxide by the semiconductor cleaning compositions of Example B8 to Example B12 did not change significantly, which proves that the semiconductor cleaning compositions can maintain good etching rates under a long-term continuous operation.

### <Decomposition Rate of Hydrogen Peroxide>

The decomposition rates of hydrogen peroxide in the semiconductor cleaning compositions of Example B4, Example B6, Example B7, Example B14, Example B15, Example B17, Example B18 and Comparative Example B5 to Comparative Example B7 are measured as follows. In the present test, a fixed amount of titanium nitride powder was dissolved in the aforementioned semiconductor cleaning composition, and placed in a water bath of 60°C for 4 hours. Then, the change in the concentration of hydrogen peroxide in the semiconductor cleaning composition before and after placed in the water bath was measured by redox titration with a potassium permanganate aqueous solution, so as to measure the change in the concentration of hydrogen peroxide in the aforementioned semiconductor cleaning composition before and after placed in the water bath. The results of the present test are listed in Table 8.

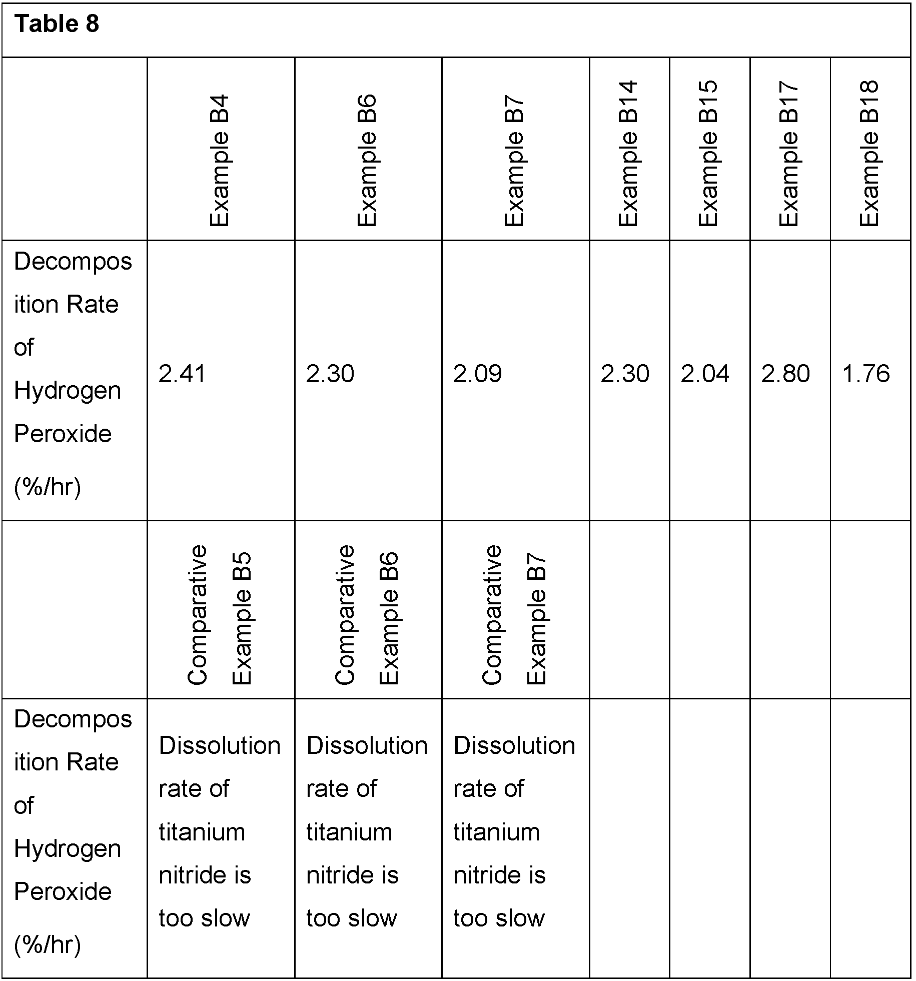

From the results in Table 8, it can be understood that the decomposition rates of hydrogen peroxide in Example B4, Example B6, Example B7, Example B14, Example B15, Example B17 and Example B18 are all not greater than 3.00%/hour. Furthermore, from Example B4, Example B6, Example B7, Example B14, Example B15 and Example B18, it can be observed that, if the chelating agent is added, the decomposition rate of hydrogen peroxide in the semiconductor cleaning composition can be reduced to less than 2.50%/hour. It proves that, by adding the chelating agent, the chelating agent and metal ions dissolved in the semiconductor cleaning composition can form a metal complex, which avoids excessive catalysis of the decomposition reaction of hydrogen peroxide by the metal ions, and maintains the reactivity of hydrogen peroxide.

In addition, in the semiconductor cleaning composition of Comparative Example B5, since the weight ratio of ammonium hydroxide to the etch stop layer corrosion inhibitor is less than 1:1, the pH value thereof is not properly adjusted, so the titanium nitride powder cannot be effectively dissolved. In the semiconductor cleaning composition of Comparative Example B6, TEAH is added as an alkaline substance. Since TEAH cannot provide sufficient stabilization effect for the dissolved metal ions, even though the pH value of Comparative Example B6 is greater than 6, the titanium nitride powder still cannot be effectively dissolved. In the semiconductor cleaning composition of Comparative Example B7, TBAH is added as an alkaline substance, and the pH value thereof is not properly adjusted, so the titanium nitride powder cannot be effectively dissolved. Therefore, Comparative Example B5 to Comparative Example B7 all have poor titanium nitride solubility.

In summary, through the selection of specific types of compounds as ingredients of the semiconductor cleaning composition and the adjustment of the ratio of ammonium hydroxide to the etch stop layer corrosion inhibitor thereof in the present disclosure, the etching rate of the semiconductor cleaning composition for etch residues, titanium compositions, metal lines, dielectric layers and etch stop layers can be controlled, which is favorable for improving the efficiency of removing etch residues and titanium compositions, and reducing the corrosion to metal lines, dielectric layers and etch stop layers.

## Claims

1. A cleaning method of a semiconductor device (100), **characterized in** comprising:
providing a semiconductor cleaning composition, which comprises a mixture and hydrogen peroxide; and
contacting a semiconductor device comprising a titanium composition and an aluminum composition, the titanium composition comprising at least one of titanium and a titanium compound, and the aluminum composition comprising at least one of aluminum and an aluminum compound, with the semiconductor cleaning composition;
wherein the mixture comprises ammonium hydroxide, an organic solvent and an etch stop layer corrosion inhibitor;
wherein the etch stop layer corrosion inhibitor is selected from a group consisting of (1-hydroxy-1-phosphonoethyl)phosphonic acid, nitrilotrimethylenetris(phosphonic acid), {ethane-1,2-diylbis[nitrilobis(methylene)]}tetrakis(phosphonic acid), [hexane-1,6-diylbis[nitrilobis(methylene)]]tetrakisphosphonic acid and [(bis{2-[bis(phosphonomethyl)amino]ethyl}amino)methyl]phosphonic acid;
wherein a weight ratio of the ammonium hydroxide to the etch stop layer corrosion inhibitor is 1:1 to 20:1;
wherein an etching rate of the semiconductor cleaning composition for the titanium composition is not less than 170 Å/min, and an etching rate of the semiconductor cleaning composition for the aluminum composition is not greater than 1 Å/min.

2. The cleaning method of the semiconductor device (100) of claim 1,
wherein making the semiconductor cleaning composition be in contact with the semiconductor device is performed by spraying the semiconductor cleaning composition onto a surface of the semiconductor device while the semiconductor device is rotated.

3. A cleaning apparatus of a semiconductor device (200), **characterized in** comprising:
a cleaning composition delivery device (210) for providing a semiconductor cleaning composition, which comprises a mixture and hydrogen peroxide; and
a cleaning chamber (220) communicated with the cleaning composition delivery device (210), wherein the cleaning chamber (220) is configured for accommodating a semiconductor device;
wherein the semiconductor cleaning composition is in contact with the semiconductor device in the cleaning chamber (220), so as to clean the semiconductor device, the semiconductor device comprises a titanium composition and an aluminum composition, the titanium composition comprises at least one of titanium and a titanium compound, and the aluminum composition comprises at least one of aluminum and an aluminum compound;
wherein the mixture comprises ammonium hydroxide, an organic solvent and an etch stop layer corrosion inhibitor;
wherein the etch stop layer corrosion inhibitor is selected from a group consisting of (1-hydroxy-1-phosphonoethyl)phosphonic acid, nitrilotrimethylenetris(phosphonic acid), {ethane-1,2-diylbis[nitrilobis(methylene)]}tetrakis(phosphonic acid), [hexane-1,6-diylbis[nitrilobis(methylene)]]tetrakisphosphonic acid and [(bis{2-[bis(phosphonomethyl)amino]ethyl}amino)methyl]phosphonic acid;
wherein a weight ratio of the ammonium hydroxide to the etch stop layer corrosion inhibitor is 1:1 to 20:1.

4. The cleaning apparatus of the semiconductor device (200) of claim 3, wherein the cleaning chamber (220) comprises a rotating element (221), the semiconductor device is disposed on the rotating element (221), and the cleaning composition delivery device (210) sprays the semiconductor cleaning composition onto a surface of the semiconductor device while the semiconductor device is rotated.

5. A semiconductor cleaning composition, **characterized in** comprising a mixture and hydrogen peroxide;
wherein the mixture comprises ammonium hydroxide, an organic solvent and an etch stop layer corrosion inhibitor;
wherein the etch stop layer corrosion inhibitor is selected from a group consisting of (1-hydroxy-1-phosphonoethyl)phosphonic acid, nitrilotrimethylenetris(phosphonic acid), {ethane-1,2-diylbis[nitrilobis(methylene)]}tetrakis(phosphonic acid), [hexane-1,6-diylbis[nitrilobis(methylene)]]tetrakisphosphonic acid and [(bis{2-[bis(phosphonomethyl)amino]ethyl}amino)methyl]phosphonic acid;
wherein a weight ratio of the ammonium hydroxide to the etch stop layer corrosion inhibitor is 1:1 to 20:1.

6. The semiconductor cleaning composition of claim 5, wherein a pH value of the mixture is 6 to 10.

7. The semiconductor cleaning composition of claim 5 or claim 6, wherein as a total weight of the semiconductor cleaning composition is 100%, a weight ratio of the hydrogen peroxide in the semiconductor cleaning composition is 10% to 25%.

8. The semiconductor cleaning composition of any one of claim 5 to claim 7, wherein the organic solvent is selected from a group consisting of alcohol, ether, glycol ether, sulfoxide, sulfone, amide, pyrrolidone and imidazolinone.

9. The semiconductor cleaning composition of any one of claim 5 to claim 8, wherein the organic solvent is selected from a group consisting of methanol, ethanol, isopropanol, n-butanol, isobutanol, ethylene glycol, 1,2-propanediol, 1,2-butanediol, 1,4-butanediol, ethylene glycol monomethyl ether, ethylene glycol dimethyl ether, ethylene glycol methyl ethyl ether, ethylene glycol monoethyl ether, ethylene glycol diethyl ether, ethylene glycol monobutyl ether, ethylene glycol tert-butyl ether, diethylene glycol, diethylene glycol monomethyl ether, diethylene glycol dimethyl ether, diethylene glycol monoethyl ether, diethylene glycol diethyl ether, diethylene glycol monobutyl ether, diethylene glycol dibutyl ether, diethylene glycol tert-butyl ether, triethylene glycol dimethyl ether, tetraethylene glycol dimethyl ether, propylene glycol dimethyl ether, propylene glycol methyl propyl ether, propylene glycol methyl butyl ether, propylene glycol monobutyl ether, propylene glycol tert-butyl ether, dipropylene glycol monomethyl ether, dipropylene glycol dimethyl ether, dipropylene glycol methyl propyl ether, dipropylene glycol methyl butyl ether, dipropylene glycol monobutyl ether, 2,5,7,10-tetraoxaundecane, 4,7-dimethyl-2,5,9-trioxadecane, 4-methyl-2,5,9-trioxadecane, tetrahydrofurfuryl alcohol, dimethyl sulfoxide, dimethyl sulfone, sulfolane, N,N-dimethylformamide, N,N-dimethylacetamide, N,N-diethylformamide, N-methyl-2-pyrrolidone, N-ethyl-2-pyrrolidone, N-isobutyl-2-pyrrolidone, 1,3-dimethylimidazolidin-2-one and tetrahydro-1,3-dimethyl-1H-pyrimidin-2-one.

10. The semiconductor cleaning composition of any one of claim 5 to claim 9, wherein the mixture further comprises water, and as a total weight of the mixture is 100%, a weight ratio of the organic solvent in the mixture is 20% to 70%.

11. The semiconductor cleaning composition of any one of claim 5 to claim 10, wherein the mixture further comprises a metal corrosion inhibitor.

12. The semiconductor cleaning composition of claim 11, wherein the metal corrosion inhibitor is selected from a group consisting of benzotriazole, 2,2'-[[(methyl-1H-benzotriazole-1-yl)methyl]imino]bisethanol, 4-nitrobenzotriazole, 5-nitrobenzotriazole, 4-methylbenzotriazole, 5-methylbenzotriazole, 1-phenylbenzotriazole, benzotriazole-4-carboxylic acid, benzotriazole-5-carboxylic acid, 4-aminobenzotriazole, 5-aminobenzotriazole, hydroxybenzotriazole, 2-(5-aminopentyl)benzotriazole and 5-benzenethiol-benzotriazole.

13. The semiconductor cleaning composition of any one of claim 5 to claim 12, wherein the mixture further comprises a chelating agent.

14. The semiconductor cleaning composition of claim 13, wherein the chelating agent is selected from a group consisting of glycine, alanine, cysteine, methionine, aspartic acid, asparagine, glutamic acid, glutamine, arginine, serine, histidine, iminodiacetic acid, nitrilotriacetic acid, N,N-bis(carboxymethyl)-β-alanine, ethylenediamine tetraacetic acid, trans-1,2-diaminocyclohexane tetraacetic acid, triethylenetetramine-N,N,N',N",N‴,N‴-hexaacetic acid, diethylenetriamine pentaacetic acid, 1,3-propanediamine-N,N,N',N'-tetraacetic acid, 1,3-diamino-2-propanol-N,N,N',N'-tetraacetic acid, glycol ether diamine tetraacetic acid, (S,S)-ethylenediamine-N,N'-disuccinic acid, N-(2-hydroxyethyl)ethylenediamine-N,N',N'-triacetic acid, N,N'-bis(2-hydroxyethl)glycine and dicarboxymethyl glutamic acid.
